# EUROPÄISCHE PATENTSCHRIFT

(11) **EP 1 115 649 B1**
(45) Veröffentlichungstag und Bekanntmachung des Hinweises auf die Patenterteilung: **11.07.2007**
(21) Anmeldenummer: 99953559.4
(22) Anmeldetag: 20.08.1999
(51) Int. Cl.: B81B 3/00, G01L 9/00

(54) **MIKROMECHANISCHES BAUELEMENT MIT VERSCHLOSSENEN MEMBRANÖFFNUNGEN**
MICROMECHANICAL COMPONENT WITH SEALED MEMBRANE OPENINGS
COMPOSANT MICROMECANIQUE A OUVERTURES DE MEMBRANES OBTUREES

(30) Priorität: 27.08.1998 DE 19839124
(43) Veröffentlichungstag der Anmeldung: 18.07.2001
(73) Patentinhaber: Infineon Technologies AG, 81669 München (DE)
(72) Erfinder: WERNER, Wolfgang, D-81545 München (DE); KOLB, Stefan, D-85716 Unterschlei heim (DE)
(74) Vertreter: Ginzel, Christian
(86) Internationale Anmeldenummer: PCT/DE1999/002625
(87) Internationale Veröffentlichungsnummer: WO 2000/012428

(56) Entgegenhaltungen:
- EP-A- 0 624 900
- WO-A-99/58985
- US-A- 5 177 661
- US-A- 5 316 619
- US-A- 5 759 870

## Beschreibung

Die Erfindung betrifft ein Verfahren zur Herstellung eines mikromechanischen Bauelements, vorzugsweise eines mikromechanischen Sensors, sowie ein mikromechanisches Bauelement umfassend einen Wafer, einen oberhalb des Wafers liegenden Hohlraum mit einer darüberliegenden Membran, mindestens eine als Auflagefläche für die Membran dienende Opferschicht und mindestens eine im Bereich des Hohlraums liegende Membranöffnung, welche mit einem Verschlußdeckel verschlossen ist, sowie dessen Verwendung in Sensoren, wie beispielsweise Drucksensoren in Mikrofonen oder Beschleunigungssensoren.

Ein mikromechanischer Sensor mit Öffnungen in der Membranschicht für Druckmessungen ist aus der EP-A 0 783 108 bekannt. Dieser Drucksensor weist einen Hohlraum auf, der oberhalb des Hohlraums im wesentlichen durch eine aus einer elektrisch leitfähigen Schicht gebildeten Membran begrenzt ist. Die Membranschicht, welche beispielsweise aus dotiertem polykristallinen Silizium oder Metall bestehen kann, bildet gemeinsam mit einer auf der Unterseite des Hohlraums angeordneten Gegenelektrode eine elektrische Kapazität, welche zur Messung der zeitlichen Volumenänderung des Hohlraums herangezogen werden kann. Die Gegenelektrode kann beispielsweise durch einen dotierten Bereich in dem zugrundeliegenden Wafer gebildet sein. Es ist auch möglich, daß in das Membranmaterial piezoresistive Elemente eingebaut sind, die Bewegungen der Membranfläche registrieren.

Der bekannte mikromechanische Sensor besteht im wesentlichen aus Materialien, die üblicherweise bei der Halbleiterherstellung eingesetzt werden. Hierdurch ist eine Anordnung des Sensors gemeinsam mit einer integrierten Ansteuer- bzw. Auswerteelektronik auf dem Chip des Sensors möglich.

Gemäß der EP-A 0 783 108 wird zur Herstellung des mikromechanischen Sensors zunächst eine Opferschicht auf ein geeignetes Wafermaterial aufgebracht. Daran schließt sich eine Beschichtung mit einem Membranmaterial unter Verwendung einer Maske an. Aufgrund der Maske entstehen in der Membranfläche Öffnungen, durch die in einem darauffolgenden Schritt durch selektiv gegenüber Substrat- und Membranmaterial ein Hohlraum geätzt wird. Gegenüber einer Ätzung des Hohlraums über laterale Kanäle ist die Vorgehensweise über ein Ätzverfahren von der Oberseite aufgrund einer verringerten Ätzzeit vorteilhaft. Nach Herstellung des Hohlraums müssen die Öffnungen in der Membran wieder verschlossen werden. Hierzu wird eine Schicht aus Borphosphorsilikatglas (BPSG) aufgebracht, deren Dicke so gewählt ist, daß über den Öffnungen in der Membran nach dem Abscheiden höchstens ein schmaler Spalt verbleibt. Im Anschluß daran wird eine Temperaturbehandlung bei etwa 1000°C durchgeführt, bei der die BPSG-Schicht zerfließt und die Löcher verschlossen werden. Auf der Oberseite und Unterseite der Membran bleibt eine Schicht aus dem Verschlußmaterial in Form einer Haut bestehen. Hierdurch entsteht ein Membranverbund, welcher aus zwei unterschiedlichen Materialien besteht. Aufgrund des unterschiedlichen Membranmaterials ergeben sich als Folge der unterschiedlichen Materialeigenschaften mechanische Belastungen sowie nicht reproduzierbare Eigenschaften des mikromechanischen Sensors. Ein weiterer Nachteil ist die Empfindlichkeit des zum Verschluß der Membranöffnungen eingesetzten Oxidmaterials gegenüber äußeren Umwelteinflüssen, wie beispielsweise Luftfeuchtigkeit.

US 5 177 661 beschreibt einen SOI Membransensor mit einer Doppelmembran aus Polysilizium und Siliziumnitrid, die einen Hochraum abschließt. Der Hohlraum wird nach Bildung der Doppelmembran durch naßchemisches Entfernen von Siliziumoxid gebildet.

US 5 316 619 beschreibt ein Verfahren zur Herstellung eines kapazitiven Sensors. Auf eine LTO-Schicht wird dazu eine Polysiliziumschicht aufgebracht und in dieser Öffnungen erzeugt. Anschließend wird die LTO-Schicht durch die Öffnungen in der Polysiliziumschicht zur Bildung eines Hohlraums entfernt. Mit einem Oxid werden die Öffnungen in der Polysiliziumschicht verschlossen.

EP 0 624 900 beschreibt ein Verfahren zur Herstellung eines integrierten Sensors. Dabei wird zunächst ein N+ Dotierungsgebiet erzeugt und dieses mit einer Epitaxieschicht bedeckt. In der Epitaxieschicht werden Öffnungen erzeugt, durch welche das N+ Dotierungsgebiet mittels eines Plasmaetchprozesses entfernt wird. Die Öffnungen in der Epitaxischicht werden mit Polysilizium verschlossen und dann eine Oxidschicht aufgebracht.

Aufgabe der vorliegenden Erfindung ist es, die Nachteile von bekannten mikromechanischen Bauelementen, vorzugsweise mikromechanischen Sensoren, mit verschlossenen Öffnungen in der Membranfläche zu überwinden. Eine weitere Aufgabe der Erfindung ist die Bereitstellung eines mikromechanischen Bauelements, vorzugsweise eines mikromechanischen Sensors, mit einer verbesserten Beständigkeit gegenüber äußeren Umwelteinflüssen.

Diese Aufgabe wird erfindungsgemäß gelöst durch ein Verfahren zur Herstellung eines mikromechanischen Bauelements nach Anspruch 1.

Bei der Entfernung von Material auf der Oberseite der ersten Membranschicht wird vorzugsweise das bei der Herstellung der Verschlußdeckel benötigte Material entfernt.

Die Freilegung der Öffnungen erfolgt bevorzugt durch Ausmaskierung von Bereichen während der Membranherstellung. Dabei ist die Form der Öffnungen beliebig und richtet sich nach der Anwendung des mikromechanischen Bauelements. Die Bereiche können beispielsweise rund, eckig oder streifenförmig sein. Es ist auch möglich, daß die Bereiche die Form von ringförmig geschlossenen Streifen haben.

Die Entfernung des Materials der Opferschicht wird vorzugsweise durch ein an sich bekanntes Ätzverfahren, welches selektiv gegenüber der Membran und dem Wafer ist, durchgeführt.

Das Aufbringen der zweiten Membranschicht auf die erste Membranschicht wird zum Schutz der verschlossenen ersten Membranschicht gegen äußere Einflüsse durchgeführt. Insbesondere werden durch die zweite Membranschicht die in der ersten Membranschicht angeordneten Verschlußdeckel gegen äußere Einflüsse geschützt.

Vorteilhafte Ausführungsformen der Erfindung sind in den Unteransprüchen beschrieben.

Ferner wird die erfindungsgemäße Aufgabe gelöst durch ein mikromechanisches Bauelement, vorzugsweise einen mikromechanischen Sensor, nach Anspruch 4.

Nach einer bevorzugten Ausführungsform der Erfindung werden die Verschlußdeckel nach einem Verfahren verschlossen, welches die Schritte a) Aufbringen eines Oxidmaterials auf der ersten Membranschicht und b) Temperaturerhöhung, so daß das aufgebrachte Oxidmaterial zerfließt und die Öffnungen verschließt, umfaßt. Je nach eingesetztem Material zum Verschluß der Öffnungen kann es während der Temperaturbehandlung durch Oberflächeneffekte zu einer Benetzung der mit dem aufgebrachten Material in Kontakt stehenden Oberflächen kommen. Diese Benetzung führt zur Bildung einer Haut aus dem Oxidmaterial. Erfindungsgemäß befindet sich auf der Oberseite der ersten Membranschicht keine derartige Oxidhaut.

Die Erfindung betrifft ferner die Verwendung der vorstehend beschriebenen erfindungsgemäßen mikromechanischen Bauelemente für Sensoren, insbesondere Drucksensoren, Mikrofone und Beschleunigungssensoren.

Vorzugsweise erfolgt die Herstellung von verschlossenen Membranen durch Aufbringen einer Abdeckschicht aus einem dotierten Glas gemäß EP-A 783 108 oder durch Aufdampfen oder Aufsputtern eines geeigneten Materials. Ein Verfahren zum Aufdampfen oder Aufsputtern einer Schicht zur Herstellung einer verschlossenen Membran ist in der DE-A 43 32 843 beschrieben.

Das mikromechanische Bauelement gemäß der vorliegenden Erfindung kann auch eine in die Membran einstrukturierte bewegliche Anordnung aufweisen, welche zur Aufnahme von Signalen bei Beschleunigungen dient. Entsprechende Strukturen sind aus dem Stand der Technik bekannt.

In einer weiteren bevorzugten Ausführungsform der Erfindung ist die zweite Membranschicht sehr viel dünner ausgebildet, als die erste Membranschicht. Die Dicke der zweiten Membranschicht liegt dann insbesondere in einem Bereich von etwa 3 nm bis etwa 1 µm.

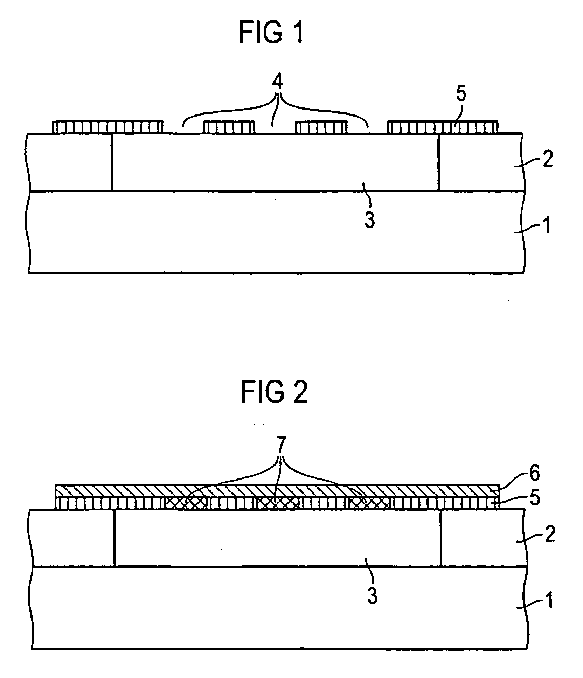

Nachfolgend wird das erfindungsgemäße Verfahren und der Aufbau eines mikromechanischen Bauelements gemäß der Erfindung anhand eines in den Figuren 1 und 2 dargestellten Ausführungsbeispiels näher erläutert.
- Figur 1: zeigt einen halbfertigen mikromechanisches Bauelement für einen Sensor mit unverschlossenen Öffnungen 4 in der ersten Membranschicht 5.
- Figur 2: zeigt ein mikromechanisches Bauelement gemäß der Erfindung für einen Sensor mit einer verschlossenen Membranstruktur.

Der in Figur 1 gezeigte halbfertige mikromechanische Sensor kann nach dem Verfahren gemäß EP-A 0 783 108 hergestellt werden, oder auch nach einem anderen im Stand der Technik üblichen Verfahren zur Herstellung von mikromechanischen Sensoren mit in der Membranfläche angeordneten Öffnungen 4. Zunächst wird auf einen Wafer 1 eine Opferschicht 2, vorzugsweise aus Siliziumoxid, aufgebracht. Anschließend erfolgt eine Beschichtung der Opferschicht mit polykristallinem Silizium, wobei im Bereich der Öffnungen 4 eine Ätzmaske aufgebracht ist. Es entstehen sogenannte Freiätzlöcher in der Membran. Die Dicke der ersten Membranschicht 5 beträgt 1µm. Die erste Membranschicht kann alternativ auch aus einkristallinem Silizium bestehen. Mit Hilfe eines isotropen Ätzprozesses wird nun die Opferschicht 2 bis zum Wafer 1 geätzt, so daß ein Hohlraum 3 unterhalb der ersten Membranschicht entsteht.

Des Weiteren wird nun nach einem üblichen Verfahren eine BPSG-Schicht auf die erste Membranfläche aufgebracht. Es kann neben BPSG auch jedes andere geeignete Material eingesetzt werden, wobei jedoch ein Oxidmaterial, wie insbesondere dotiertes Glas, Siliziumdioxid oder mit Bor und/oder mit Phosphor dotiertes Glas, bevorzugt eingesetzt wird. Es folgt ein thermischer Verfließprozeß bei etwa 800 bis 1100 °C, welcher zur Bildung einer Haut auf der ersten Membranschicht 5 führt. Nach dem Verfließprozeß sind die Öffnungen 4 mit Verschlußdeckeln 7 aus BPSG verschlossen. Es ist jedoch auch möglich, daß die Öffnungen bereits ohne einen Verfließprozeß bereits hinreichend verschlossen sind, beispielsweise wenn die Öffnungen klein sind oder die Schicht von ausreichender Dicke ist. Die Größe der Öffnungen 4 wird so gewählt, daß ein Verschluß der Öffnungen durch das BPSG-Material erfolgt. Wird ein Verfließprozeß durchgeführt, so richtet sich die maximale Größe der Öffnungen im wesentlichen nach der Oberflächenspannung des Beschichtungsmaterial bei der verwendeten Verfließtemperatur und der Dicke der ersten Membranfläche. Aufgrund von Oberflächeneffekten bildet sich oberhalb der ersten Membranfläche eine Haut aus Verschlußmaterial mit einer Dicke, welche bevorzugt im Bereich von etwa 0,1 µm bis etwa 1 µm liegt. Wie in Figur 2 gezeigt, wird nun ein Rückätzprozeß durchgeführt, bei dem die auf der ersten Membranschicht befindliche Haut aus Verschlußmaterial restlos entfernt wird. Es entsteht eine ebenflächige erste Membranschicht 5. Verschlußmaterial bleibt lediglich in den Öffnungen 4 zurück. Der Rückätzprozeß kann naßchemisch oder trocken durchgeführt werden, wobei sich die Ätzzeit nach der Dicke der zum Verschluß aufgebrachten Schicht richtet. Wird die Ätzzeit zu groß gewählt, so entsteht keine ebenflächige erste Membranschicht. Wird die Ätzdauer dagegen zu kurz gewählt, so verbleiben unerwünschte Reste des zum Verschluß eingesetzten Materials auf der Membran. Im Anschluß an die Rückätzung wird eine zweite Membranschicht 6 auf die erste Membranschicht abgeschieden. Das Material für die zweite Membranschicht wird dabei bevorzugt so gewählt, daß die mechanischen Eigenschaften mit den mechanischen Eigenschaften der ersten Membranschicht weitestgehend übereinstimmen. Als Material für die zweite Membranschicht wird erfindungsgemäß polykristallines Silizium verwendet.

Das erfindungsgemäße mikromechanische Bauelement verhält sich gegenüber äußeren Einflüssen, wie Luftfeuchtigkeit neutral, d. h. daß sich seine Eigenschaften, wie beispielsweise die Sensoreigenschaften und die Sensorkennlinie, nach längerer Einsatzdauer praktisch nicht ändern.

Ein weiterer Vorteil des erfindungsgemäßen mikromechanischen Bauelements ist es, daß die Oberfläche der Membranstruktur bestehend aus erster und zweiter Membranfläche ebenflächig ausgebildet werden kann. Dies ist insbesondere bei der Montage des mikromechanischen Bauteils in einem Gehäuse eines Sensors von Vorteil.

## Patentansprüche

1. Verfahren zur Herstellung eines mikromechanischen Bauelements umfassend die Schritte
- Herstellung eines halbfertigen mikromechanischen Bauelements umfassend einen Wafer (1), eine erste Membranschicht (5) und eine oder mehrere als Auflage für die erste Membranschicht dienende Opferschichten (2) auf an sich bekannte Weise,
- Herstellung von Öffnungen (4) nach oder während des Aufbringens der ersten Membranschicht,
- Entfernung von Material der Opferschicht (2) zur Bildung eines Hohlraums (3) durch die Öffnungen (4) hindurch,
- Verschließen der Öffnungen (4) mit Verschlußdeckeln (7) und
- Entfernung von Material auf der Oberseite der ersten Membranschicht, wobei die Oberfläche der ersten Membranschicht freigelegt und planarisiert wird, wobei
nach der Freilegung und Planarisierung der ersten Membranschicht eine zweite Membranschicht (6) auf die erste Membranschicht aufgebracht wird und die erste und zweite Membranschicht aus dem gleichen Material bestehen.

2. Verfahren zur Herstellung eines mikromechanischen Bauelements nach Anspruch 1, **dadurch gekennzeichnet, daß** die Entfernung von Verschlußmaterial durch Rückätzung erfolgt, wobei entweder naßchemisch oder trocken geätzt wird.

3. Verfahren zur Herstellung eines mikromechanischen Bauelements nach Ansprüche 1 oder 2, **dadurch gekennzeichnet, daß** die Herstellung der Verschlußdeckel durch Abscheidung eines Oxidmaterials auf der ersten Membranschicht, Erhitzung auf eine Temperatur, bei der das abgeschiedene Oxidmaterial fließt und die Öffnungen verschließt und Abkühlung auf eine Temperatur, bei der das Oxidmaterial erhärtet, erfolgt.

4. Mikromechanisches Bauelement umfassend einen Wafer (1), einen oberhalb des Wafers liegenden Hohlraum (3), eine oberhalb des Hohlraums angeordnete erste Membranschicht (5), mindestens eine als Auflagefläche für die erste Membranschicht dienende Opferschicht (2), mindestens eine im Bereich des Hohlraums liegende Membranöffnung (4), welche mit einem Verschlußdeckel (7) verschlossen ist, wobei das Material des Verschlußdeckels nicht dem Material der ersten Membranschicht entspricht, wobei auf der Oberseite der ersten Membranschicht im wesentlichen keine Haut aus einem Material angeordnet ist, welches dem Material der Verschlußdeckel (7) entspricht, und sich unmittelbar auf der ersten Membranschicht (5) eine zweite Membranschicht (6) befindet,
**dadurch gekennzeichnet,**
**daß** die erste und zweite Membranschicht aus dem gleichen Material bestehen.

5. Mikromechanisches Bauelement nach Anspruch 4, **dadurch gekennzeichnet, daß** der Verschlußdeckel aus einem Oxid besteht.

6. Mikromechanisches Bauelement nach Anspruch 4 oder 5, **dadurch gekennzeichnet, daß** die erste Membranschicht gemeinsam mit den Verschlußdeckeln zumindest auf der Oberseite der ersten Membranschicht eine weitestgehend ebene Fläche bildet.

7. Mikromechanisches Bauelement nach mindestens einem der Ansprüche 4 bis 6, **dadurch gekennzeichnet, daß** auf dem Chip des Bauelements eine Ansteuer- und/oder Auswerteschaltung vorhanden ist.

8. Mikromechanisches Bauelement nach mindestens einem der Ansprüche 4 bis 7, **dadurch gekennzeichnet, daß** die Dicke der ersten Membranschicht im Bereich von etwa 0,2 bis etwa 20 µm liegt.

9. Mikromechanisches Bauelement nach mindestens einem der Ansprüche 4 bis 8, **dadurch gekennzeichnet, daß** die Dicke der zweiten Membranschicht im Bereich von etwa 0,01 µm bis 10 µm liegt.

10. Verwendung des mikromechanischen Bauelements nach Anspruch 4 für Sensoren.

## Claims

1. Method for producing a micromechanical component comprising the steps of
- producing a semi-finished micromechanical component comprising a wafer (1), a first membrane layer (5) and one or more sacrificial layers (2) serving as support for the first membrane layer in a way known per se,
- producing openings (4) after or during the application of the first membrane layer,
- removing material of the sacrificial layer (2) through the openings (4) in order to form a cavity (3),
- sealing the openings (4) with sealing covers (7), and
- removing material on the top side of the first membrane layer, the surface of the first membrane layer being exposed and planarized,
a second membrane layer (6) being applied to the first membrane layer after the first membrane layer has been exposed and planarized and the first and second membrane layers consisting of the same material.

2. Method for producing a micromechanical component according to Claim 1, **characterized in that** the removal of sealing material is performed by back etching, either by wet chemical or dry etching.

3. Method for producing a micromechanical component according to Claim 1 or 2, **characterized in that** the sealing covers are produced by depositing an oxide material on the first membrane layer, heating it to a temperature at which the deposited oxide material flows and seals the openings, and cooling it to a temperature at which the oxide material hardens.

4. Micromechanical component comprising a wafer (1), a cavity (3) situated above the wafer, a first membrane layer (5) arranged above the cavity, at least one sacrificial layer (2) serving as support surface for the first membrane layer, at least one membrane opening (4) which is situated in the region of the cavity and is sealed with a sealing cover (7), the material of the sealing cover not corresponding to the material of the first membrane layer, essentially no skin of a material which corresponds to the material of the sealing covers (7) being arranged on the top side of the first membrane layer, and a second membrane layer (6) being located directly on the first membrane layer (5) **characterized in that** the first and second membrane layers consist of the same material.

5. Micromechanical component according to Claim 4, **characterized in that** the sealing cover consists of an oxide.

6. Micromechanical component according to Claim 4 or 5, **characterized in that** in common with the sealing covers the first membrane layer forms a surface which is as flat as possible, at least on the top side of the first membrane layer.

7. Micromechanical component according to at least one of Claims 4 to 6, **characterized in that** a drive and/or evaluation circuit is present on the chip of the component.

8. Micromechanical component according to at least one of Claims 4 to 7, **characterized in that** the thickness of the first membrane layer is in the range of approximately 0.2 to approximately 20 µm.

9. Micromechanical component according to at least one of Claims 4 to 8, **characterized in that** the thickness of the second membrane layer is in the range of approximately 0.01 µm to 10 µm.

10. Use of the micromechanical component according to Claim 4 for sensors.

## Revendications

1. Procédé de production d'un composant micromécanique, comprenant les stades dans lesquels :
- on produit un composant micromécanique semi fini comprenant une tranche (1), une première couche (15) de membrane et une ou plusieurs couches (2) sacrificielle servant de support à la première couche de membrane d'une manière en soi connue,
- on ménage des ouvertures après ou pendant le dépôt de la première couche de membrane,
- on élimine de la matière de la couche (2) sacrificielle pour former une cavité (3) en passant dans les ouvertures (4),
- on ferme les ouvertures (4) par des couvercles (7) de fermeture et
- on élimine de la matière de la face supérieure de la première couche de membrane, la surface de la première couche de membrane étant mise à nu et planarisée, dans lequel
après la mise à nu et la planarisation de la première couche de membrane, on dépose une deuxième couche (6) de membrane sur la première couche de membrane et la première et la deuxième couche de membrane sont en la même matière.

2. Procédé de production d'un composant micromécanique suivant la revendication 1, **caractérisé en ce que** l'on effectue l'élimination de la matière de fermeture par attaque en retrait, l'attaque s'effectuant en voie chimique humide ou à sec.

3. Procédé de production suivant les revendications 1 ou 2, **caractérisé en ce que** l'on effectue la production du couvercle de fermeture par dépôt d'une matière d'oxyde sur la première couche de membrane, chauffage à une température à laquelle la matière d'oxyde déposée s'écoule et ferme les ouvertures et refroidissement à une température à laquelle la matière d'oxyde durcit.

4. Composant micromécanique, comprenant une tranche (1), une cavité (3) se trouvant au-dessus de la tranche, une première couche (5) de membrane disposée au dessus de la cavité, au moins une couche (2) sacrificielle servant de surface d'appui à la première couche de membrane, au moins une ouverture (4) de membrane se trouvant dans la zone de la cavité et fermée par un couvercle (7) de fermeture, dans lequel la matière du couvercle de fermeture ne correspond pas à la matière de la première couche de membrane, dans lequel sur la face supérieure de la première couche de membrane il n'y a sensiblement pas de peau en une matière qui correspond à la matière du couvercle (7) de fermeture et une deuxième (6) couche (6) de membrane se trouvant directement sur la première couche (5) de membrane,
**caractérisé en ce que**
la première et la deuxième couches de membrane sont en la même matière.

5. Composant micromécanique suivant la revendication 4, **caractérisé en ce que** le couvercle de fermeture est en un oxyde.

6. Composant micromécanique suivant la revendication 4 ou 5, **caractérisé en ce que** la première couche de membrane forme conjointement avec les couvercles de fermetures une surface dans une grande mesure au moins plane sur la face supérieure de la première couche de membrane.

7. Composant micromécanique suivant au moins l'une des revendications 4 à 6, **caractérisé en ce qu'**il y a un circuit de commande et/ou d'exploitation sur la puce du composant.

8. Composant micromécanique suivant au moins l'une des revendications 4 à 7, **caractérisé en ce que** l'épaisseur de la première couche de membrane et de l'ordre d'environ 0,2 à environ 20 µm.

9. Composant micromécanique suivant au moins l'une des revendications 4 à 8, **caractérisé en ce que** l'épaisseur de la deuxième couche de membrane est de l'ordre d'environ 0,01 µm à 10 µm.

10. L'utilisation du composant micromécanique suivant la revendication 4 pour des capteurs.
